# EUROPEAN PATENT APPLICATION

(11) **EP 4 718 496 A1**
(43) Date of publication of application: **01.04.2026**
(21) Application number: 25205098.4
(22) Date of filing: 26.09.2025
(51) Int. Cl.: H01J 37/32

(54) **RADIO FREQUENCY SENSOR AND METHOD FOR MONITORING OF PLASMA STATUS**

(30) Priority: 27.09.2024 KR 20240131428
(71) Applicant: Korea Institute of Fusion Energy, Daejeon 34133 (KR)
(72) Inventor: KIM, Dae Chul, Gunsan-si, Jeonbuk-do 54101 (KR); SONG, Jung Ho, Sejong-si 30092 (KR); CHO, Ki Hwan, Dong-gu, Daejeon 34509 (KR); KIM, Young-Woo, Hwaseong-si, Gyeonggi-do 18443 (KR); KIM, Jongsik, Gunsan-si, Jeonbuk-do 54138 (KR); KIM, Yonghyun, Hwaseong-si, Gyeonggi-do 18366 (KR); YOON, Jung-Sik, Dong-gu, Daejeon 34696 (KR); PARK, Jong-Bae, Gunsan-si, Jeonbuk-do 54086 (KR); SHIN, Jong hyeon, Gunsan-si, Jeonbuk-do 54161 (KR); PARK, Sanghyeok, Anseong-si, Gyeonggi-do 17608 (KR)
(74) Representative: Dehns

(57) **Abstract**

The present disclosure relates to a radio frequency (RF) sensor (100) and a method for monitoring plasma status. The RF sensor includes a collector (120) configured to collect, as sensing data, an induced electromotive force induced during a plasma process; and a processor (130) configured to record the induced electromotive force as a function of time, perform Fourier transformation on the recorded induced electromotive force function to derive an amplitude value of an n-th harmonic (where n is a natural number equal to or greater than 1), and apply the derived amplitude value and a setting value of plasma equipment identified at the time of sensing data generation to an artificial intelligence algorithm to derive prediction data capable of monitoring plasma status and plasma process status. The RF sensor may also be applied in other embodiments.

## Description

### BACKGROUND

### 1. Technical Field

The present disclosure relates to a radio frequency (RF) sensor and a method for monitoring plasma status.

### 2. Related Art

In general, during a semiconductor device manufacturing process, plasma equipment that performs etching, deposition, and the like on a semiconductor substrate using plasma generated by high-frequency power is widely used. Various sensors are attached to such plasma equipment, and the operation and operating status of the plasma equipment or its components are checked based on sensing data acquired from the sensors.

At present, the sensing data acquired from sensors attached to plasma equipment are analyzed to perform determinations such as the start and end points of a plasma process, whether plasma is generated, whether there is a functional abnormality, the end point of wafer etching, and whether process by-products generated inside the plasma equipment have been removed. However, the accuracy of such determinations is very low, and thus problems arise in that the process may be stopped during the plasma process, normal operation may be determined as abnormal operation, or abnormal operation may be determined as normal operation, which frequently occurs and leads to reduced productivity.

Accordingly, there is a need for the development of a technology capable of more accurately determining plasma status or plasma process status so as to solve the problem of reduced productivity.

### SUMMARY

Exemplary embodiments of the present disclosure, which have been devised to solve the above-described conventional problems, are directed to providing an RF sensor and a method for performing plasma status monitoring, in which an artificial intelligence algorithm mounted on the RF sensor is trained using sensing data acquired from at least one RF sensor attached to plasma equipment, and data related to plasma status are derived based on the trained result to monitor the plasma status.

The RF sensor for performing plasma status monitoring, according to an embodiment of the present disclosure, may include a collector configured to collect, as sensing data, an induced electromotive force induced during a plasma process; and a processor configured to record the induced electromotive force as a function of time, perform Fourier transformation on the recorded induced electromotive force function to derive an amplitude value of an n-th harmonic (where n is a natural number equal to or greater than 1), and apply the derived amplitude value and a setting value of plasma equipment identified at the time of sensing data generation to an artificial intelligence algorithm to derive prediction data capable of monitoring plasma status and plasma process status.

In addition, the processor may be configured to perform verification of the prediction data.

In addition, the processor may be configured to determine, based on a verification result of the verification, whether to stop the plasma process or whether retraining of the artificial intelligence algorithm is required.

In addition, the RF sensor may further include a communicator, and the communicator may be configured to transmit the prediction data verified by the processor to an electronic device.

In addition, a method for performing plasma status monitoring, according to an embodiment of the present disclosure, may include collecting, by an RF sensor, an induced electromotive force induced during a plasma process as sensing data; recording, by the RF sensor, the induced electromotive force as a function of time, and performing Fourier transformation on the recorded induced electromotive force function to derive an amplitude value of an n-th harmonic (where n is a natural number equal to or greater than 1); and deriving, by the RF sensor, prediction data capable of monitoring plasma status and plasma process status by applying the derived amplitude value and a setting value of plasma equipment identified at the time of sensing data generation to an artificial intelligence algorithm.

In addition, the method may further include performing, by the RF sensor, verification of the prediction data.

In addition, the method may further include determining, by the RF sensor, whether to stop the plasma process or whether retraining of the artificial intelligence algorithm is required based on the verified verification result.

In addition, the method may further include transmitting, by the RF sensor, a process stop request message of the plasma process to an electronic device when it is determined that the plasma process needs to be stopped.

In addition, the method may further include performing, by the RF sensor, retraining of the artificial intelligence algorithm when retraining of the artificial intelligence algorithm is required.

In addition, the method may further include transmitting, by the RF sensor, the prediction data verified through the verification to an electronic device.

As described above, the RF sensor and the method for performing plasma status monitoring according to the present disclosure can monitor plasma status by training an artificial intelligence algorithm mounted on the RF sensor using sensing data acquired from at least one RF sensor attached to plasma equipment and deriving data related to plasma status based on the trained result.

### BRIEF DESCRIPTION OF THE DRAWINGS

FIG. 1 is a diagram illustrating a system including an RF sensor for performing plasma status monitoring according to an embodiment of the present disclosure.
FIG. 2 is a flowchart illustrating a method for monitoring plasma status in an RF sensor according to an embodiment of the present disclosure.

### DETAILED DESCRIPTION OF EMBODIMENTS

This invention was made with support from the National Research and Development Program of Korea. The information of the supported project is as follows:
[Assignment Unique Number] 1711203519
[Assignment Number] CRC20014-000
[Name of the Ministry] Korea Ministry of Science and ICT
[Name of the Assignment Managing (Professional) Organization] National Research Council of Science & Technology (NST)
[Research Project Title] National Research Council of Science & Technology (NST) Research Operation Expense Support (Major Project Expense) - Future-Oriented Convergence Research Program
[Assignment Title] Development and Demonstration of Intelligent Semiconductor Plasma Process Equipment Technology
[Name of the Organization Performing the Assignment] Korea Institute of Fusion Energy (KFE)
[Research Period] 2020.11.01-2026.10.31

Hereinafter, preferred embodiments according to the present disclosure will be described in detail with reference to the accompanying drawings. The detailed description to be disclosed hereinafter with the accompanying drawings is intended to describe exemplary embodiments of the present disclosure and is not intended to represent the only embodiments in which the present disclosure may be implemented. In the drawings, parts unrelated to the description may be omitted for clarity of description of the present disclosure, and throughout the specification, same or similar reference numerals denote same elements.

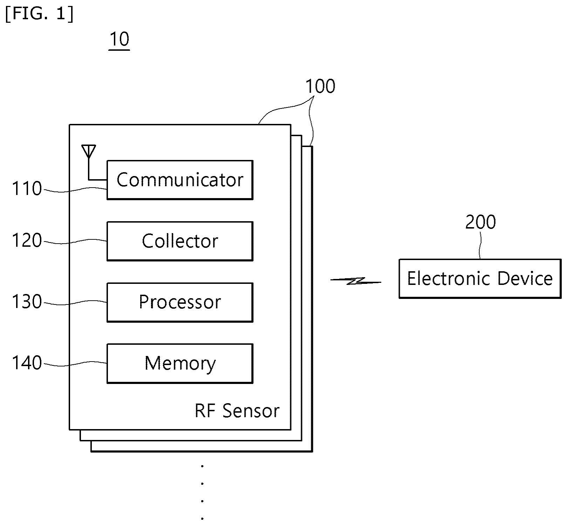

FIG. 1 is a diagram illustrating a system including an RF sensor for performing plasma status monitoring according to an embodiment of the present disclosure.

Referring to FIG. 1, the system 10 according to the present disclosure may include a plurality of RF sensors 100 and an electronic device 200.

Each of the plurality of RF sensors 100 may include a communicator 110, a collector 120, a processor 130, and a memory 140. In addition, although an RF sensor will be described in an embodiment of the present disclosure, it should be clearly understood that the description applies to all of the plurality of RF sensors 100. The RF sensor 100 may be a sensor capable of sensing a signal having a radio frequency (RF) and may include a coil. In this case, the coil may be a wire member forming at least one closed surface with a conducting wire, which means a wire member in which an electromotive force is induced so that a current can flow through the conducting wire when a change occurs in a magnetic field passing through the closed surface formed by the conducting wire.

The RF sensor 100 is disposed outside plasma equipment, namely, an inductively coupled plasma (ICP) generator including an antenna, in at least one position. The RF sensor 100 is not limited as long as it is disposed around the antenna, particularly above the antenna, at a position where an induced electromotive force can be induced. For example, a spiral-shaped antenna may be formed on an upper plane of the plasma equipment, and the RF sensor 100 may be disposed so as to be perpendicular to the plane on which the spiral-shaped antenna is formed.

The communicator 110 transmits result data derived by the processor 130 to the electronic device 200 in order to monitor plasma status and plasma process status through communication with the electronic device 200. To this end, the communicator 110 may perform communication with the electronic device 200 through Wi-Fi (wireless fidelity), Bluetooth, BLE (Bluetooth low energy), or the like.

The collector 120 collects, as sensing data, an induced electromotive force induced in the RF sensor 100 during a plasma process. At this time, the collector 120 may measure a physical quantity such as current, rather than the induced electromotive force, and calculate the electromotive force to measure the induced electromotive force. The plasma equipment may generate plasma inside the plasma equipment through a current applied to the antenna and a change in the current, and a change in a surrounding magnetic field may occur from the antenna. Accordingly, the collector 120 may collect, as sensing data, an induced electromotive force induced from the change in the magnetic field.

The processor 130 performs preprocessing of the sensing data. More specifically, the processor 130 may perform Fourier transformation on the induced electromotive force collected by the collector 120 from a function of the induced electromotive force over time. Fourier transformation may decompose a function with respect to time into frequency components, and the frequency components may be numbered in order from a fundamental frequency component to a first harmonic, a second harmonic, and so on. In the context of the present specification, the term "harmonic" refers to a frequency component resulting from Fourier transformation, wherein an n-th harmonic means the n-th component harmonic wave in the order of significance of the frequency components appearing in the Fourier transformation result, and an amplitude value of the n-th harmonic refers to an amplitude value of the harmonic wave.

As such, the processor 130 may perform preprocessing by recording the induced electromotive force as a function of time, performing Fourier transformation on the recorded induced electromotive force function to separate respective frequency components, and deriving amplitude values of the respective frequency components or of a specific n-th harmonic (where n is a natural number equal to or greater than 1). At this time, it may be determined, according to the value of n, how close the frequency of the harmonic is to the main frequency component of the function of time of the induced electromotive force.

The processor 130 applies the derived amplitude value and a setting value at the time of sensing data acquisition to an artificial intelligence algorithm to perform learning of the artificial intelligence algorithm. At this time, the setting value may include a plasma status (for example, electron density and electron temperature) and a plasma process status (for example, a process such as an etching process) at the time of sensing data acquisition.

The processor 130 may adjust the number of learning iterations, the sensing data load size, the number of layers, and the like for learning accuracy. In addition, the processor 130 may provide a function of finding a setting value that derives the best result value by repeatedly inputting setting values within a predetermined range. At this time, the setting values within the predetermined range may refer to values set through a GridSearchCV technique for finding learning conditions that can most accurately predict the result value of learning.

The processor 130 may input test data into the artificial intelligence algorithm to check prediction accuracy and time consumed for prediction, and may use only learning results that meet accuracy and response time set by a user of the RF sensor 100. At this time, the processor 130 may set one or more learning performance results that meet the accuracy and response time set by the user. Through this, the processor 130 may continuously log predicted values as learning is repeated and select the artificial intelligence algorithm having the highest accuracy. The processor 130 stores the trained artificial intelligence algorithm in the memory 140.

The processor 130 applies the preprocessed amplitude value to the trained artificial intelligence algorithm to generate prediction data for plasma status and plasma process status. At this time, the prediction data may include the amplitude value applied to the artificial intelligence algorithm, a prediction time, the artificial intelligence algorithm used for the prediction, a prediction result (plasma status and plasma process status), and an actual measured value.

The processor 130 verifies the prediction data by comparing the prediction data predicted by the processor 130 with actual measurement results acquired in an inspection process performed after an actual plasma process is completed. At this time, the processor 130 may compare the prediction data with the actual measurement results periodically or in real time.

The processor 130 may determine that the plasma process is in a state requiring process stop when the number of times an error between the prediction data and the actual measurement result exceeds a tolerance range included in preset verification information is greater than or equal to a threshold, and may transmit a message to the electronic device 200 indicating that the plasma process needs to be stopped.

The processor 130 may determine that retraining of the artificial intelligence algorithm is required when the number of times an error between the prediction data and the actual measurement result exceeds a tolerance range included in preset verification information is greater than or equal to a threshold. At this time, the criteria for determining whether to stop the plasma process and the criteria for determining whether retraining of the artificial intelligence algorithm is required may be different. When the processor 130 determines that retraining of the artificial intelligence algorithm is required, the processor 130 performs retraining of the artificial intelligence algorithm.

In addition, when retraining of the artificial intelligence algorithm is not required or when retraining has been completed, the processor 130 applies the preprocessed amplitude value to the trained artificial intelligence algorithm in the RF sensor 100, thereby generating prediction data for plasma status and plasma process status, and transmits the generated prediction data to the electronic device 200. Through this, the electronic device 200 may monitor the plasma status and the plasma process status predicted by the RF sensor 100.

The memory 140 stores operation programs for operating the RF sensor 100. More specifically, the memory 140 may store the artificial intelligence algorithm trained by the processor 130.

The electronic device 200 is a device capable of controlling plasma equipment (not shown) through communication with the plasma equipment, and may be an electronic device such as a computer, a notebook computer, or a tablet PC. The electronic device 200 displays prediction data received from at least one RF sensor 100 so that a user can check plasma status and plasma process status. In addition, the electronic device 200 controls operation of the plasma equipment based on the prediction data received from the RF sensor 100.

More specifically, the electronic device 200 may plan parameter values to be controlled during process execution in the plasma equipment based on prediction data received from at least one RF sensor 100. When a plasma status value identified based on the prediction data deviates from a preset range by a threshold or more, the electronic device 200 may receive, from a user, input regarding a changed item of plasma status, an amount of change, process parameters, the number of processes, process execution time, and the like.

The electronic device 200 may receive, from a user, input regarding process impact related to a changed item of plasma status when a plasma process status identified based on the prediction data deviates from a range of preset process status by a threshold or more.

The electronic device 200 may generate a control combination based on controllable control factors in parameter control combination conditions having information on controllable items in at least one process in which an identified predicted plasma status value deviates from a range of preset plasma status values by a threshold or more, or an identified process status deviates from a range of preset process status by a threshold or more.

The process control combination may be trained by applying sensing data acquired from a performed process, and plasma status values and plasma process status predicted corresponding to the sensing data, to a reinforcement learning algorithm, which is an artificial intelligence algorithm.

When prediction of the process control combination is completed using the reinforcement learning algorithm, the electronic device 200 performs process impact evaluation on the predicted control combination. The process impact evaluation determines whether the control combination exists within a range defined in preset parameter control constraints, and if the control combination falls within the preset range, control information of a parameter control recommendation combination and parameter adjustment amounts may be stored as data for more stably controlling the plasma equipment.

The electronic device 200 may perform control of parameter values for the plasma equipment based on the set process control combination.

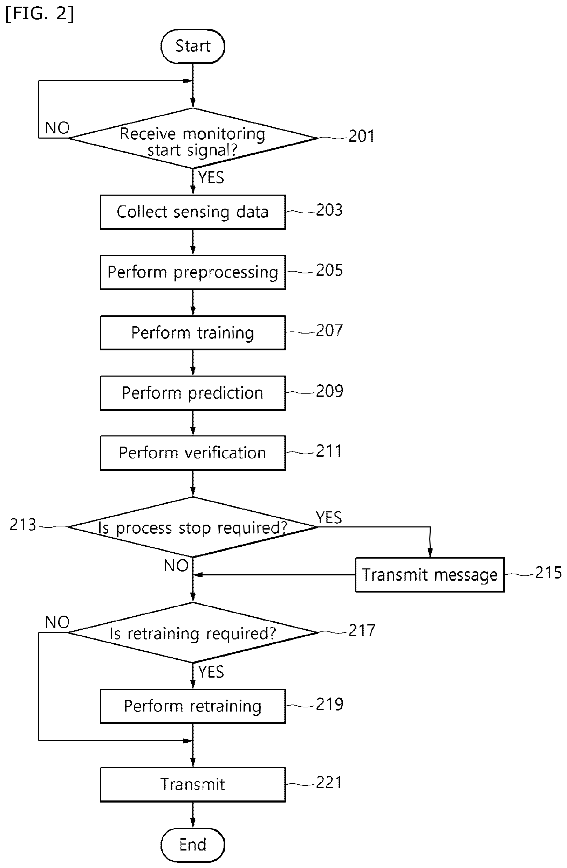

FIG. 2 is a flowchart illustrating a method for monitoring plasma status in an RF sensor according to an embodiment of the present disclosure.

In step 201, when a start signal for monitoring plasma status and plasma process status of plasma equipment is received, the processor 130 performs step 203, and when the start signal is not received, the processor 130 waits for reception of the start signal. At this time, the start signal may be an activation signal of the RF sensor 100 received from the electronic device 200 through the communicator 110.

In step 203, the collector 120 collects sensing data. At this time, the sensing data may refer to an induced electromotive force induced in the RF sensor 100 during a plasma process. In addition, the collector 120 may measure a physical quantity such as current and calculate an electromotive force to measure the induced electromotive force.

In step 205, the processor 130 performs preprocessing of the sensing data. More specifically, the processor 130 may record the induced electromotive force collected by the collector 120 as a function of time, perform Fourier transformation on the recorded induced electromotive force function to identify component frequencies, and derive amplitude values of the identified component frequencies. As such, the processor 130 may perform preprocessing by deriving amplitude values of an n-th harmonic (where n is a natural number equal to or greater than 1).

In step 207, the processor 130 applies the derived amplitude value and a setting value at the time of sensing data acquisition to an artificial intelligence algorithm to perform learning of the artificial intelligence algorithm. At this time, the setting value may include a plasma status (for example, electron density and electron temperature) and a plasma process status (for example, a process such as an etching process) at the time of sensing data acquisition.

The processor 130 may adjust the number of learning iterations, the sensing data load size, the number of layers, and the like for learning accuracy. In addition, the processor 130 may provide a function of finding a setting value that derives the best result value by repeatedly inputting setting values within a predetermined range. At this time, the setting values within the predetermined range may refer to values set through a GridSearchCV technique for finding learning conditions that can most accurately predict the result value of learning.

The processor 130 may input test data into the artificial intelligence algorithm to check prediction accuracy and time consumed for prediction, and may use only learning results that meet accuracy and response time set by a user of the RF sensor 100. At this time, the processor 130 may set one or more learning performance results that meet the accuracy and response time set by the user. Through this, the processor 130 may continuously log predicted values as learning is repeated and select the artificial intelligence algorithm having the highest accuracy. The processor 130 stores the trained artificial intelligence algorithm in the memory 140.

In step 209, the processor 130 applies the preprocessed amplitude value to the trained artificial intelligence algorithm to generate prediction data for plasma status and plasma process status. At this time, the prediction data may include the amplitude value applied to the artificial intelligence algorithm, a prediction time, the artificial intelligence algorithm used for the prediction, a prediction result (plasma status and plasma process status), and an actual measured value.

In step 211, the processor 130 verifies the prediction data by comparing the prediction data predicted by the processor 130 with actual measurement results acquired in an inspection process performed after an actual plasma process is completed. At this time, the processor 130 may compare the prediction data with the actual measurement results periodically or in real time.

In step 213, when verification indicates that the plasma process needs to be stopped, the processor 130 performs step 215, and when the plasma process does not need to be stopped, the processor 130 performs step 217. More specifically, the processor 130 may determine that the plasma process is in a state requiring process stop when the number of times an error between the prediction data and the actual measurement result exceeds a tolerance range included in preset verification information is greater than or equal to a threshold.

In step 215, the processor 130 may generate a message indicating that the plasma process needs to be stopped and transmit the message to the electronic device 200.

Conversely, in step 217, the processor 130 checks whether retraining of the artificial intelligence algorithm is required. More specifically, the processor 130 may determine that retraining of the artificial intelligence algorithm is required when the number of times an error between the prediction data and the actual measurement result exceeds a tolerance range included in preset verification information is greater than or equal to a threshold. At this time, the criteria for determining whether to stop the plasma process and the criteria for determining whether retraining of the artificial intelligence algorithm is required may be different.

As a result of the check in step 217, when it is determined that retraining of the artificial intelligence algorithm is required, the processor 130 performs step 219, and when it is determined that retraining is not required, the processor 130 performs step 221. In step 219, the processor 130 performs retraining of the artificial intelligence algorithm.

Conversely, when retraining of the artificial intelligence algorithm is not required or when retraining has been completed, in step 221, the processor 130 applies the preprocessed amplitude value to the trained artificial intelligence algorithm in the RF sensor 100, thereby generating prediction data for plasma status and plasma process status, and transmits the generated prediction data to the electronic device 200. Through this, the electronic device 200 may monitor the plasma status and the plasma process status predicted by the RF sensor 100.

The embodiments of the present disclosure disclosed in the present specification and drawings are only provided as specific examples to easily describe the technical content of the present disclosure and to aid understanding of the present disclosure, and are not intended to limit the scope of the present disclosure. Therefore, the scope of the present disclosure should be construed that all changes or modifications derived based on the technical spirit of the present disclosure in addition to the embodiments disclosed herein are included in the scope of the present disclosure.

## Claims

1. An RF sensor for performing plasma status monitoring, comprising:
a collector configured to collect, as sensing data, an induced electromotive force induced during a plasma process; and
a processor configured to record the induced electromotive force as a function of time, perform Fourier transformation on the recorded induced electromotive force function to derive an amplitude value of an n-th harmonic (where n is a natural number equal to or greater than 1), and apply the derived amplitude value and a setting value of plasma equipment identified at the time of sensing data generation to an artificial intelligence algorithm to derive prediction data capable of monitoring plasma status and plasma process status.

2. The RF sensor for performing plasma status monitoring according to claim 1, wherein the processor is configured to perform verification of the prediction data.

3. The RF sensor for performing plasma status monitoring according to claim 2, wherein the processor is configured to determine, based on a verification result of the verification, whether to stop the plasma process or whether retraining of the artificial intelligence algorithm is required.

4. The RF sensor for performing plasma status monitoring according to claim 3,
further comprising a communicator,
wherein the communicator is configured to transmit the prediction data verified by the processor to an electronic device.

5. A method for performing plasma status monitoring, comprising:
collecting, by an RF sensor, an induced electromotive force induced during a plasma process as sensing data;
recording, by the RF sensor, the induced electromotive force as a function of time, and performing Fourier transformation on the recorded induced electromotive force function to derive an amplitude value of an n-th harmonic (where n is a natural number equal to or greater than 1); and
deriving, by the RF sensor, prediction data capable of monitoring plasma status and plasma process status by applying the derived amplitude value and a setting value of plasma equipment identified at the time of sensing data generation to an artificial intelligence algorithm.

6. The method for performing plasma status monitoring according to claim 5, further comprising performing, by the RF sensor, verification of the prediction data.

7. The method for performing plasma status monitoring according to claim 6, further comprising determining, by the RF sensor, whether to stop the plasma process or whether retraining of the artificial intelligence algorithm is required based on the verified verification result.

8. The method for performing plasma status monitoring according to claim 7, further comprising transmitting, by the RF sensor, a process stop request message of the plasma process to an electronic device when it is determined that the plasma process needs to be stopped.

9. The method for performing plasma status monitoring according to claim 7, further comprising performing, by the RF sensor, retraining of the artificial intelligence algorithm when retraining of the artificial intelligence algorithm is required.

10. The method for performing plasma status monitoring according to claim 7, further comprising transmitting, by the RF sensor, the prediction data verified through the verification to an electronic device.
